(19) **Europäisches Patentamt / European Patent Office / Office européen des brevets**

(11) **EP 3 489 700 B1**

(12) **EUROPEAN PATENT SPECIFICATION**

(45) Date of publication and mention
of the grant of the patent:
**19.08.2020 Bulletin 2020/34**

(21) Application number: **16910449.4**

(22) Date of filing: **25.07.2016**

(51) Int Cl.:
*G01R 31/34* (2020.01)   *H02P 29/024* (2016.01)

(86) International application number:
**PCT/JP2016/071705**

(87) International publication number:
**WO 2018/020545 (01.02.2018 Gazette 2018/05)**

(54) **ELECTRIC MOTOR DIAGNOSIS DEVICE**

ELEKTROMOTORDIAGNOSEVORRICHTUNG

DISPOSITIF DE DIAGNOSTIC DE MOTEUR ÉLECTRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**29.05.2019 Bulletin 2019/22**

(73) Proprietor: **Mitsubishi Electric Corporation**
**Chiyoda-ku**
**Tokyo 100-8310 (JP)**

(72) Inventors:
• **MIYAUCHI Toshihiko**
**Tokyo 100-8310 (JP)**
• **KANEMARU Makoto**
**Tokyo 100-8310 (JP)**
• **MORI Mitsugi**
**Tokyo 100-8310 (JP)**

• **TSUKIMA Mitsuru**
**Tokyo 100-8310 (JP)**

(74) Representative: **Witte, Weller & Partner**
**Patentanwälte mbB**
**Postfach 10 54 62**
**70047 Stuttgart (DE)**

(56) References cited:
WO-A1-2015/071242    WO-A1-2016/103909
WO-A1-2016/103909    JP-A- 2002 010 681
JP-A- 2003 070 287    JP-A- 2003 070 287
JP-A- 2005 012 879    JP-A- 2005 012 879
JP-A- 2006 158 031    JP-A- 2006 158 031
JP-A- 2011 257 362    JP-A- 2013 033 459
JP-A- 2013 106 470    US-B1- 6 262 550

EP 3 489 700 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

TECHNICAL FIELD

The present invention relates to an electric motor diagnosis device which is used in, for example, a control center that is an enclosed switchboard, and which performs diagnosis as to whether or not there is an abnormality in an electric motor.

BACKGROUND ART

Conventionally, a model-based failure detection system has been proposed in which measurement is performed to obtain real-time information about the motor speed and input voltages and currents of an electric motor, a result obtained by performing modeling and the result of the measurement are compared to each other, a comparison result regarding an error generated by performing subtraction on respective signals is evaluated, and the error is analyzed by a diagnostic observer, thereby determining whether or not a failure has occurred in the electric motor (for example, Patent Document 1). JP 2003 070287 A discloses a motor controller comprising a position/speed control section receiving a motor position and outputting a torque command by performing positional control and speed control such that the motor position matches a target position command.

CITATION LIST

PATENT DOCUMENT

Patent Document 1: Japanese Translation of PCT International Application Publication No. 2000-513097

SUMMARY OF THE INVENTION

PROBLEMS TO BE SOLVED BY THE INVENTION

In the conventional model-based failure detection system, the following problems arise: since measurement is performed to obtain real-time information about the motor speed and input voltages and currents of an electric motor, and a result obtained by performing modeling and the result of the measurement are compared to each other, a reference model is required, and furthermore, since whether or not a failure has occurred is determined through comparison with the real-time information obtained by the measurement, it is difficult to apply the system to an electric motor of which the load greatly varies.

The present invention has been made to solve the above problems, and an object of the present invention is to provide an electric motor diagnosis device capable of performing diagnosis as to whether or not there is an abnormality in an electric motor, by performing statistic process on load torques calculated from information about voltages and currents having been sampled and inputted, even if the load of the electric motor varies.

SOLUTION TO THE PROBLEMS

An electric motor diagnosis device according to the present invention includes: a load torque calculation unit for calculating load torques of an electric motor with use of voltages and currents having been sampled and inputted from a main circuit to which the electric motor is connected; a histogram calculation unit for calculating an average value and a standard deviation of a probability density function of the load torques which are equal in number to samples and which are calculated by the load torque calculation unit, to obtain a histogram, wherein the number of samples is equal to a number of the load torques, wherein the histogram is a graph with a horizontal axis being a load torque value and with a vertical axis being the probability density with the probability density function expressed in a normal distribution; and an abnormality determination unit for calculating a peak ratio of a largest peak and a second largest peak value and for setting a threshold value for the peak ratio, whereby a cyclic torque abnormality can be detected, and to determine whether or not there is an abnormality in the electric motor, if two or more peak parts exist in the histogram obtained by the histogram calculation unit.

EFFECT OF THE INVENTION

The present invention includes: the load torque calculation unit for calculating load torques of an electric motor with use of voltages and currents having been sampled and inputted from a main circuit to which the electric motor is connected; the histogram calculation unit for calculating an average value and a standard deviation of a probability density function of the load torques which are equal in number to samples and which are calculated by the load torque calculation unit, to obtain a histogram, wherein the number of samples is equal to a number of the load torques, wherein the histogram is a graph with a horizontal axis being a load torque value and with a vertical axis being the probability density with the probability density function expressed in a normal distribution; and the abnormality determination unit for calculating a peak ratio of a largest peak value and a second largest peak value and for setting a threshold value for the peak ratio, whereby a cyclic torque abnormality can be detected, and to determine whether or not there is an abnormality in the electric motor, if two or more peak parts exist in the histogram obtained by the histogram calculation unit. Therefore, the present invention exhibits an advantageous effect of obtaining an electric motor diagnosis device capable of performing diagnosis as to whether or not there is an abnormality in the electric motor, by performing statistic process on the load torques which are equal in number to samples and which are calculated from information about voltages and currents having been sampled and inputted.

BRIEF DESCRIPTION OF THE DRAWINGS

[FIG. 1] FIG. 1 is a schematic configuration diagram showing an installation state of an electric motor diagnosis device according to embodiment 1 of the present invention.

[FIG. 2] FIG. 2 is a block diagram showing a configuration of a logical calculation unit of the electric motor diagnosis device according to embodiment 1 of the present invention.

[FIG. 3] FIG. 3 is a block diagram showing a configuration of a storage unit of the electric motor diagnosis device according to embodiment 1 of the present invention.

[FIG. 4] FIG. 4 is a diagram for explaining the relationship between sampling speed, and forgetting coefficient and scale factor, in the electric motor diagnosis device according to embodiment 1 of the present invention.

[FIG. 5] FIG. 5 is a flowchart for explaining an operation of the electric motor diagnosis device according to embodiment 1 of the present invention.

[FIG. 6] FIG. 6 is a diagram for explaining a histogram of load torques, in the electric motor diagnosis device according to embodiment 1 of the present invention.

[FIG. 7] FIG. 7 is a diagram for explaining a case where a peak part of a histogram in an abnormal state is shifted from that of a histogram in a normal state, in the electric motor diagnosis device according to embodiment 1 of the present invention.

[FIG. 8] FIG. 8 is a diagram for explaining a Mahalanobis distance of the histogram in the electric motor diagnosis device according to embodiment 1 of the present invention.

[FIG. 9] FIG. 9 is a diagram for explaining threshold-value-based determination performed with use of the Mahalanobis distance, in the electric motor diagnosis device according to embodiment 1 of the present invention.

[FIG. 10] FIG. 10 is a diagram for explaining a case where there are two peak parts of a histogram in an abnormal state unlike a histogram in a normal state, in the electric motor diagnosis device according to embodiment 1 of the present invention.

[FIG. 11] FIG. 11 is a diagram for explaining a peak ratio of the two peak parts of the histogram in an abnormal state, in the electric motor diagnosis device according to embodiment 1 of the present invention.

[FIG. 12] FIG. 12 is a diagram for explaining threshold-value-based determination performed with use of the peak ratio, in the electric motor diagnosis device according to embodiment 1 of the present invention.

DESCRIPTION OF EMBODIMENTS

Hereinafter, an embodiment of the present invention will be described. In the drawings, the same or the corresponding components are denoted by the same reference characters.

Embodiment 1

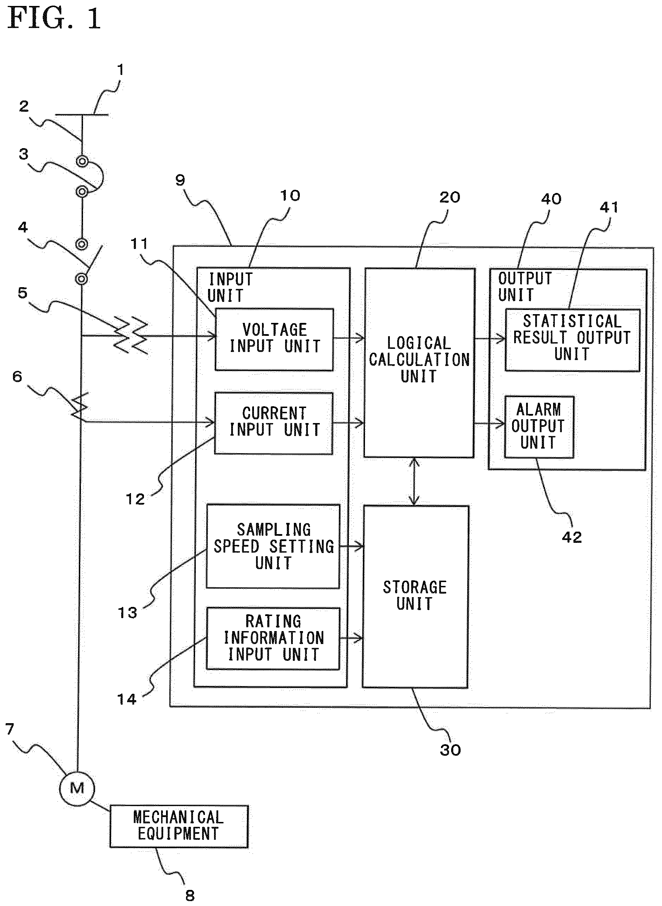

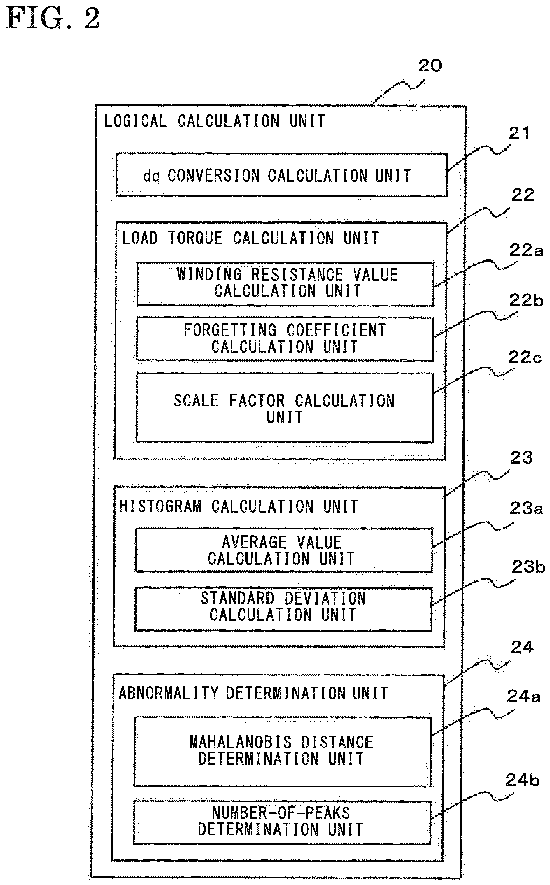

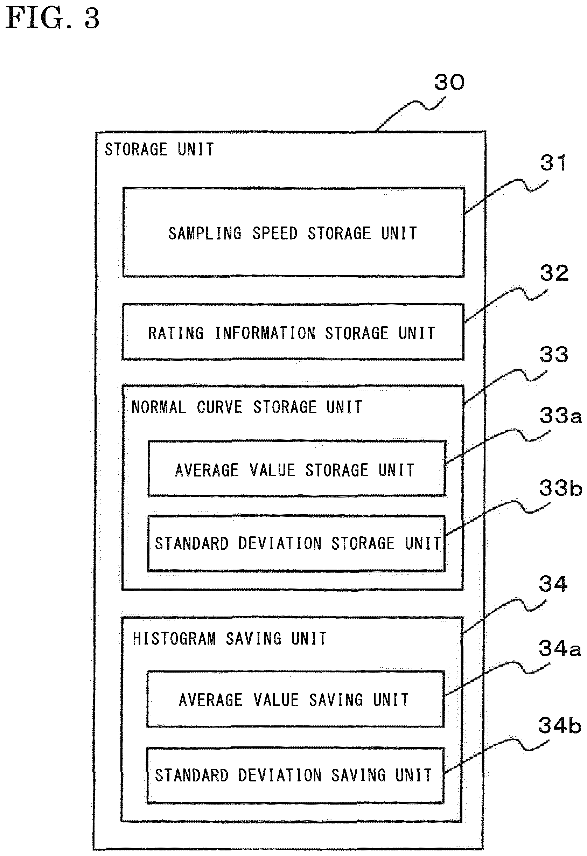

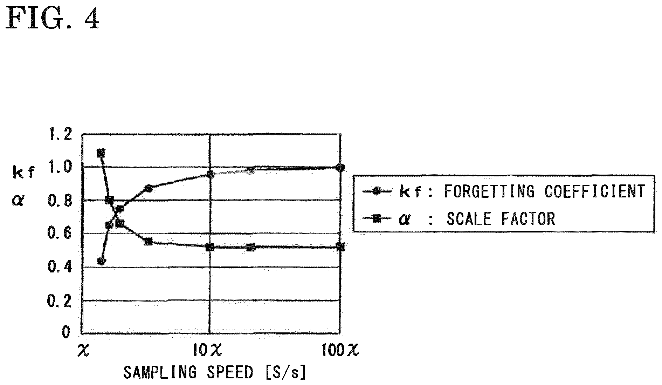

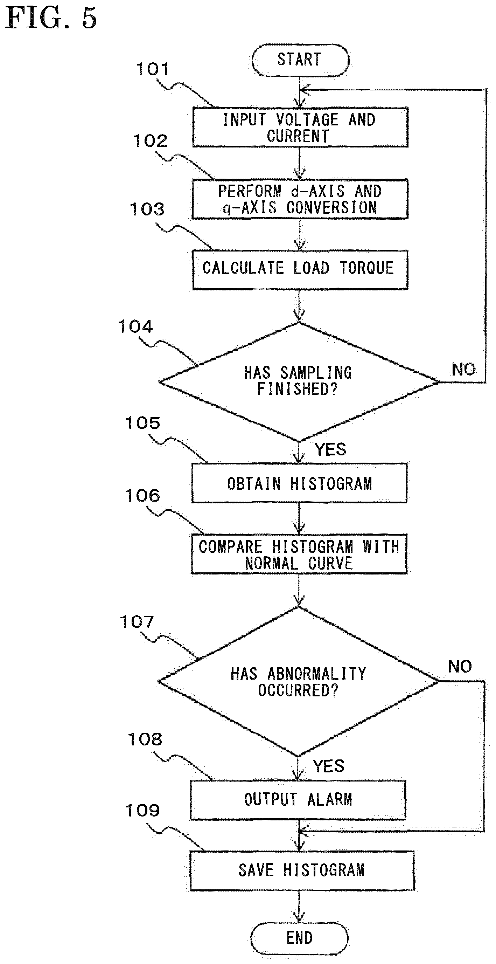

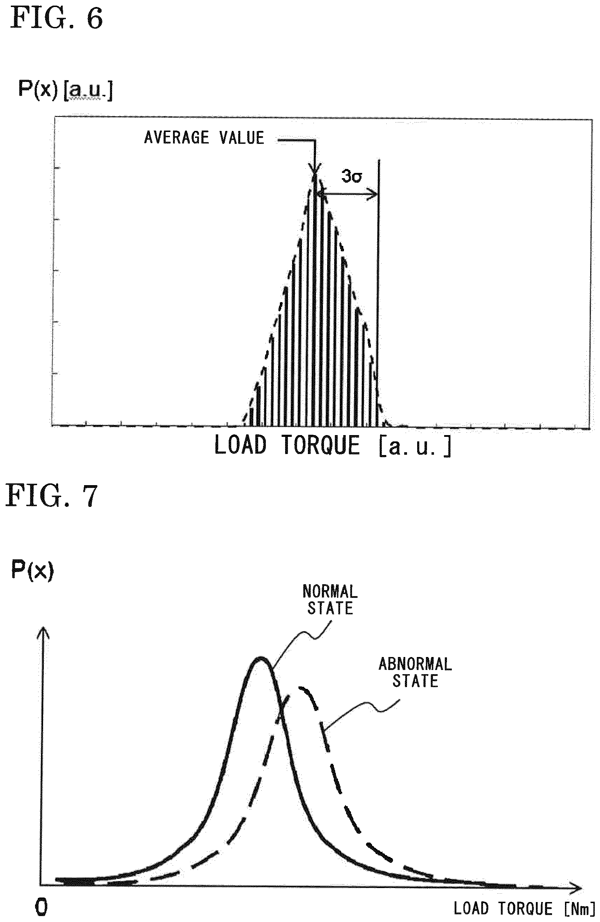

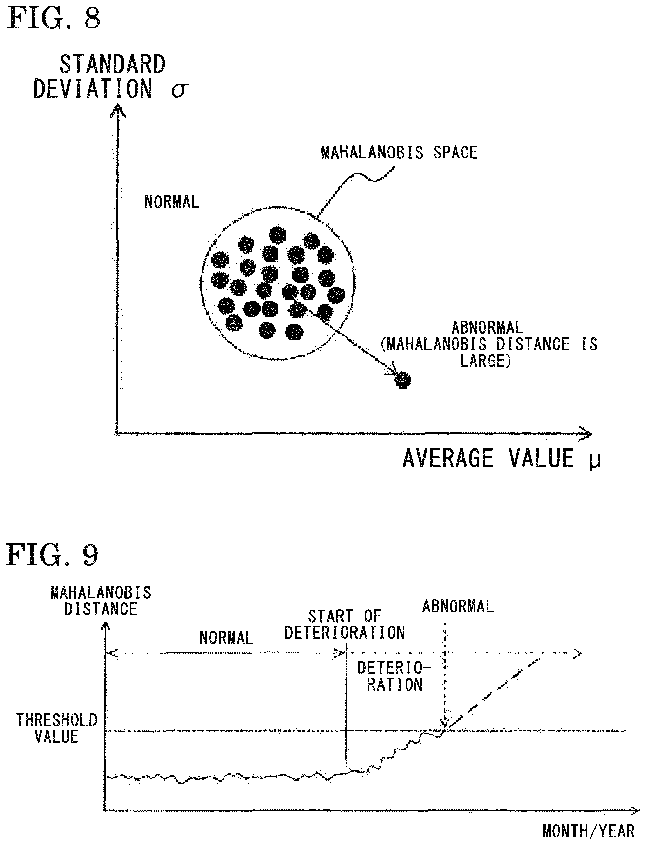

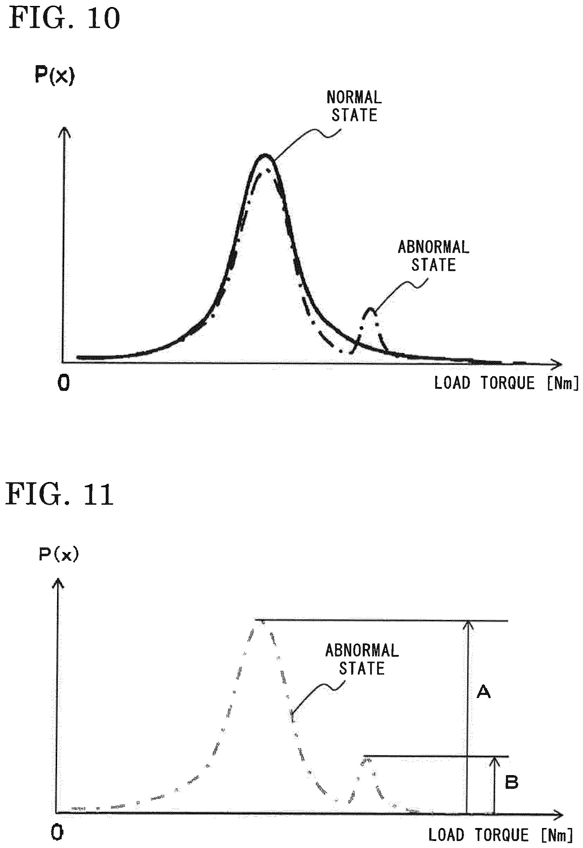

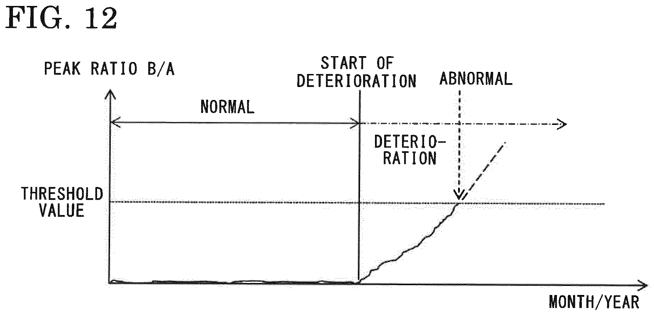

FIG. 1 is a schematic configuration diagram showing an installation state of an electric motor diagnosis device according to embodiment 1 of the present invention. FIG. 2 is a block diagram showing a configuration of a logical calculation unit of the electric motor diagnosis device according to embodiment 1 of the present invention. FIG. 3 is a block diagram showing a configuration of a storage unit of the electric motor diagnosis device according to embodiment 1 of the present invention. FIG. 4 is a diagram for explaining the relationship between sampling speed, and forgetting coefficient and scale factor, in the electric motor diagnosis device according to embodiment 1 of the present invention. FIG. 5 is a flowchart for explaining an operation of the electric motor diagnosis device according to embodiment 1 of the present invention. FIG. 6 is a diagram for explaining a histogram of load torques, in the electric motor diagnosis device according to embodiment 1 of the present invention. FIG. 7 is a diagram for explaining a case where a peak part of a histogram in an abnormal state is shifted from that of a histogram in a normal state, in the electric motor diagnosis device according to embodiment 1 of the present invention. FIG. 8 is a diagram for explaining a Mahalanobis distance of the histogram in the electric motor diagnosis device according to embodiment 1 of the present invention. FIG. 9 is a diagram for explaining threshold-value-based determination performed with use of the Mahalanobis distance, in the electric motor diagnosis device according to embodiment 1 of the present invention. FIG. 10 is a diagram for explaining a case where there are two peak parts of a histogram in an abnormal state unlike a histogram in a normal state, in the electric motor diagnosis device according to embodiment 1 of the present invention. FIG. 11 is a diagram for explaining a peak ratio of the two peak parts of the histogram in an abnormal state, in the electric motor diagnosis device according to embodiment 1 of the present invention. FIG. 12 is a diagram for explaining threshold-value-based determination performed with use of the peak ratio, in the electric motor diagnosis device according to embodiment 1 of the present invention.

In FIG. 1, a main circuit 2 which is led in from a power system 1 is provided with: a wiring circuit breaker 3; an electromagnetic contactor 4; a voltage detector 5 such as an instrument voltage transformer for detecting, for two inter-phase portions, inter-phase voltages of the three-phase main circuit 2; and a current detector 6 such as an instrument current transformer for detecting, for two phases, load currents of the main circuit 2. An electric motor 7 such as a three-phase induction motor which is a load is connected to the main circuit 2, and mechanical equipment 8 is driven so as to be operated by the electric motor 7. An electric motor diagnosis device 9 is used mainly in a control center that is an enclosed switchboard, and the electric motor diagnosis device 9 is composed of an input unit 10, a logical calculation unit 20, a storage unit 30, and an output unit 40.

The input unit 10 is provided with: a voltage input unit 11 to which voltages detected by the voltage detector 5 are inputted at a preset sampling speed (hereinafter, referred to as "sampled and inputted"); a current input unit 12 to which currents detected by the current detector 6 are sampled and inputted; a sampling speed setting unit 13 for setting a sampling speed; and a rating information input unit 14 to which rating information about the electric motor 7 and the like are inputted.

The sampling speed setting unit 13 performs setting such that sampling is performed for 10 seconds at a sampling speed of 100 samples per second, for example. Accordingly, 1000 sampled data are to be obtained. The set sampling speed and the like are stored in a sampling speed storage unit 31 shown in FIG. 3, of the storage unit 30.

In the rating information input unit 14, a power supply frequency, the rated output, the rated voltage, the rated current, the rated rotation rate, etc., of the electric motor 7, and the number of magnetic poles, a winding resistance value, etc., used for calculation of load torque, are inputted in advance, and the inputted rating information and the like are stored in a rating information storage unit 32 shown in FIG. 3, of the storage unit 30. The rating information and the like are information that can be easily acquired through reference to a catalog of the manufacturer of the electric motor 7 or a rating plate attached to the electric motor 7. It is noted that, if there are a plurality of the electric motors 7 to be diagnosed, rating information about all the electric motors 7 to be diagnosed needs to be inputted in advance.

The configuration of the logical calculation unit 20 will be described with reference to FIG. 2. The logical calculation unit 20 is provided with: a dq conversion calculation unit 21 for converting voltage inputted from the voltage input unit 11 and current inputted from the current input unit 12, into voltage and current in the d-axis direction and the q-axis direction (hereinafter, referred to as dq-axis directions) suitable for calculation of load torque; a load torque calculation unit 22 for calculating load torque with use of the voltage and the current that are obtained as a result of the conversion by the dq conversion calculation unit 21; a histogram calculation unit 23 for obtaining a histogram with use of the load torques which are equal in number to samples and which are calculated by the load torque calculation unit 22; and an abnormality determination unit 24 for determining whether or not there are abnormalities in the electric motor 7 and the mechanical equipment 8, through comparison between the histogram obtain by the histogram calculation unit 23 and a histogram in a normal state stored in advance in a normal curve storage unit 33 shown in FIG. 3, of the storage unit 30.

In addition, a winding resistance value calculation unit 22a for obtaining a winding resistance value Rs of a stator winding of the electric motor 7, and a forgetting coefficient calculation unit 22b and a scale factor calculation unit 22c for calculating a forgetting coefficient $kf$ and a scale factor $\alpha$, respectively, from a sampling speed, are provided as the units for obtaining and setting, in advance, data to be used in the load torque calculation unit 22.

Generally, when the temperature of the stator winding of the electric motor 7 rises, the winding resistance value Rs increases, and thus, it is possible that, for example, a correlation between the temperature and the winding resistance value Rs obtained through experiments conducted by the manufacturer of electric motor 7 or the like is set in the rating information storage unit 32 in advance, and the temperature of the stator winding at the time of sampling of voltages and currents is detected and inputted, whereby the winding resistance value Rs is accurately obtained from the set correlation by the winding resistance value calculation unit 22a. Alternatively, the winding resistance value Rs may also be obtained by being calculated from detected voltage and current. Thus, the method for calculation by the winding resistance value calculation unit 22a is not limited to the above-described method.

There is a correlation as shown in FIG. 4 between sampling speed, and forgetting coefficient kf and scale factor α. Therefore, for example, a correlation in FIG. 4 obtained as a result of actual measurement performed in advance by the manufacturer of the diagnosis device is set as a data table in the storage unit 30, and, when a sampling speed and the like are set by the sampling speed setting unit 13, a forgetting coefficient kf and a scale factor α are obtained by the forgetting coefficient calculation unit 22b and the scale factor calculation unit 22c, respectively, with use of the stored data table, and are set and stored in the sampling speed storage unit 31 shown in FIG. 3. Once the sampling speed is first set, the sampling speed under the same condition is applied to all the subsequent diagnoses for that electric motor.

The histogram calculation unit 23 is provided with: an average value calculation unit 23a for calculating the average value of the load torques which are equal in number to samples and which are obtained by the load torque calculation unit 22; and a standard deviation calculation unit 23b for calculating a standard deviation.

The abnormality determination unit 24 is provided with a Mahalanobis distance determination unit 24a and a number-of-peaks determination unit 24b for determining whether or not there is an abnormality in accordance with the state of abnormality, of which operations will be described in details later.

The configuration of the storage unit 30 will be described with reference to FIG. 3. The storage unit 30 is provided with: the sampling speed storage unit 31 for storing the sampling speed set by the sampling speed setting unit 13, and the like; the rating information storage unit 32 for storing rating information about the electric motor 7 and the like inputted from the rating information input unit 14; the normal curve storage unit 33 for storing the histogram in a normal state serving as a reference for determination as to abnormality; and a histogram saving unit 34 for saving, in time series, the histograms obtained by the histogram calculation unit 23.

In addition, the normal curve storage unit 33 is provided with an average value storage unit 33a and a standard deviation storage unit 33b for respectively storing an average value and a standard deviation which are the base data for the histogram in a normal state. The histogram saving unit 34 is provided with an average value saving unit 34a and a standard deviation saving unit 34b for respectively saving average values and standard deviations which are the base data for the histograms.

The output unit 40 is provided with: a statistical result output unit 41 for displaying and outputting, for example, a comparison result obtained by the abnormality determination unit 24 comparing histograms in a normal state and in an abnormal state with each other, a result obtained by the Mahalanobis distance determination unit 24a performing trend analysis on Mahalanobis distances, and a result obtained by the number-of-peaks determination unit 24b performing trend analysis on peak ratios; and an alarm output unit 42 for performing alarm output by means of, for example, emission of an alarm sound or lighting of an abnormality lamp when the abnormality determination unit 24 has determined that there is an abnormality.

Next, operations will be described with reference to a flowchart shown in FIG. 5. The electric motor diagnosis device 9 is activated at predetermined time intervals, e.g., every 10 minutes, and performs diagnosis as to abnormality in the electric motor 7 and the like.

In step 101, voltages vuv and vvw for two inter-phase portions are inputted from the voltage input unit 11 at a sampling speed that is set by the sampling speed setting unit 13 and that is stored in the sampling speed storage unit 31, and currents iu and iv for two phases are sampled and inputted from the current input unit 12.

In step 102, the dq conversion calculation unit 21 converts the inputted voltages and currents into voltages and currents in the dq-axis directions.

Calculation by the dq conversion calculation unit 21 will be described. First, since, in dq conversion of three-phase currents, only current information for two phases is sufficient if three phases u, v, and w are balanced, a current id in the d-axis direction and a current iq in the q-axis direction are calculated with a conversion formula shown in expression (1), using the currents iu and iv for two phases inputted from the current input unit 12.

[Mathematical 1]

$$\begin{pmatrix} i_d \\ i_q \end{pmatrix} = \begin{pmatrix} \frac{2}{3} & -\frac{1}{3} & -\frac{1}{3} \\ 0 & \frac{1}{\sqrt{3}} & -\frac{1}{\sqrt{3}} \end{pmatrix} \begin{pmatrix} i_u \\ i_v \\ -(i_u + i_v) \end{pmatrix} = \begin{pmatrix} 1 & 0 \\ \frac{1}{\sqrt{3}} & \frac{2}{\sqrt{3}} \end{pmatrix} \begin{pmatrix} i_u \\ i_v \end{pmatrix} \quad \cdots (1)$$

Similarly, also in the case of voltage, only voltage information for two phases is sufficient. However, ordinarily, voltage is often measured as line-to-line voltage. Therefore, using voltages vuv and vvw for two inter-phase portions (the subscript uv denotes "between u phase and v phase", and the subscript vw denotes "between v phase and w phase") inputted from the voltage input unit 11, a voltage vd in the d-axis direction and a voltage vq in the q-axis direction are calculated with a conversion formula shown in expression (2).

[Mathematical 2]

$$\begin{pmatrix} v_d \\ v_q \end{pmatrix} = \begin{pmatrix} \dfrac{2}{3} & \dfrac{1}{3} \\ 0 & \dfrac{1}{\sqrt{3}} \end{pmatrix} \begin{pmatrix} v_{uv} \\ v_{vw} \end{pmatrix} \qquad \cdots \cdots \cdots \cdots \cdots (2)$$

In step 103, the load torque calculation unit 22 calculates load torques with use of the voltages and the currents in the dq-axis directions obtained as a result of conversion by the dq conversion calculation unit 21.

The calculation by the load torque calculation unit 22 will be described. The load torque calculation unit 22 calculates a load torque Te by means of expression (3) with use of: the currents id and iq in the dq-axis directions obtained by being calculated by the dq conversion calculation unit 21; the number Pp of magnetic poles of the electric motor 7, which is inputted from the rating information input unit 14 and stored in the rating information storage unit 32 in advance; and interlinkage magnetic fluxes φd and φq in the dq-axis directions of the stator winding of the electric motor 7.

[Mathematical 3]

$$T_e = \frac{3}{2} \cdot P_p \cdot \left\{ (\phi_d \cdot i_q) - (\phi_q \cdot i_d) \right\} \qquad \cdots \cdots \cdots (3)$$

Here, the interlinkage magnetic fluxes φα and φq in the dq-axis directions can be obtained through calculation by means of expression (4) to expression (9). Expression (4) and expression (5) are expressed with derivative, and thus expression (6) and expression (7) are obtained through numerical analysis. Values calculated by means of expression (8) and expression (9) which are obtained by respectively multiplying results of calculation of expression (6) and expression (7) by a scale factor α, are identified values obtained as final results of the interlinkage magnetic fluxes. The calculation result of expression (8) corresponds to the interlinkage magnetic flux φd, and the calculation result of expression (9) corresponds to the interlinkage magnetic flux φq.

[Mathematical 4]

$$\frac{d\phi_d}{dt} = v_d - \left( i_d \cdot R_s \right) \qquad \cdots \cdots \cdots \cdots \cdots (4)$$

[Mathematical 5]

$$\frac{d\phi_q}{dt} = v_q - \left( i_q \cdot R_s \right) \qquad \cdots \cdots \cdots \cdots \cdots (5)$$

[Mathematical 6]

$$\Psi_d^n = k_f \cdot \Psi_d^{n-1} + \left\{ v_d^{n-1} + v_d^n - (i_d^{n-1} + i_d^n) \cdot R_s \right\} \cdot \frac{\Delta t}{2} \qquad \cdots (6)$$

[Mathematical 7]

$$\Psi_q^n = k_f \cdot \Psi_q^{n-1} + \left\{ v_q^{n-1} + v_q^n - (i_q^{n-1} + i_q^n) \cdot R_s \right\} \cdot \frac{\Delta t}{2} \qquad \cdots (7)$$

[Mathematical 8]

$$\hat{\Psi}_d^n = \alpha \cdot \Psi_d^n \qquad \cdots\cdots\cdots\cdots (8)$$

[Mathematical 9]

$$\hat{\Psi}_q^n = \alpha \cdot \Psi_q^n \qquad \cdots\cdots\cdots\cdots (9)$$

It is noted that the symbols used in expression (4) to expression (9) denote the following data: vd and vq denote voltages in the dq-axis directions calculated by the dq conversion calculation unit 21; id and iq denote currents in the dq-axis directions calculated by the dq conversion calculation unit 21; Rs denotes the winding resistance value calculated by the winding resistance value calculation unit 22a; kf denotes the forgetting coefficient calculated by the forgetting coefficient calculation unit 22b; $\alpha$ denotes the scale factor calculated by the scale factor calculation unit 22c; $\Psi$ is a symbol that indicates numerical analysis of the interlinkage magnetic fluxes; the subscript n is a variable that indicates usage of an n-th value of sampling; and the subscript n-1 is a variable that indicates usage of an (n-1)th value of sampling. Therefore, n takes values of 1, 2, 3···. $\Delta t$ denotes a sampling time width and is a value determined by the sampling speed. For example, if the sampling speed is 100 samples per second, the sampling time width $\Delta t$ is 0.01.

In step 104, by the above-described operations from step 101 to step 103 being repeated until the sampling is finished, the number of values of the load torques (hereinafter, referred to as load torque values) obtained through calculation by the load torque calculation unit 22 is, for example, 1000 which is equal to the number of samples.

In step 105, the histogram calculation unit 23 expresses, in a probability density function, the load torque values which are equal in number to samples and which are obtained by the load torque calculation unit 22. Then, an average value $\mu$ and a standard deviation $\sigma$ of the probability density function in which the variable is a load torque value Tk, are calculated by means of expression (10) and expression (11) by the average value calculation unit 23a and the standard deviation calculation unit 23b, respectively. p(k) in the expressions denotes the probability of the load torque values Tk.

[Mathematical 10]

$$\mu = \sum_{k=1}^{N} T_k p(k) \qquad \cdots\cdots\cdots\cdots (10)$$

[Mathematical 11]

$$\sigma = \sqrt{\sigma^2} = \sqrt{\sum_{k=1}^{N} (T_k - \mu)^2 p(k)} \qquad \cdots\cdots\cdots (11)$$

The probability density function is expressed in a normal distribution if the load torque value randomly varies. In this case, if a graph is created with the horizontal axis being load torque value and with the vertical axis being probability density, the graph is expressed as a histogram shown in FIG. 6. The probability density is the highest at the average value, and a smooth curve is formed with the average value being the center thereof.

Here, acquisition of a normal curve that needs to be performed as initial settings in which the electric motor diagnosis device 9 is introduced, will be described. At a time when it can be confirmed that there is no fault in a relatively new electric motor 7 and mechanical equipment 8 at an initial stage of equipment introduction, the above-described operations from step 101 to step 105 are performed to obtain a histogram, and a curve obtained at this time is stored as one in a normal state in the normal curve storage unit 33. However, owing to variation in a loaded state at the time of measurement, the average value and the standard deviation vary. Thus, measurement is performed a plurality of times, a curve assumed to be the most appropriate is selected, and, as a histogram in a normal state, the curve is stored in the normal curve storage unit 33, the average value storage unit 33a, and the standard deviation storage unit 33b. As a criterion for selecting the normal curve, a curve having a satisfactory curve shape in the normal distribution and having a relatively large average value is selected, for example. The histogram in a normal state stored in the normal curve storage unit 33 in this manner is to serve as a reference for determination as to abnormality.

In step 106, the abnormality determination unit 24 determines whether or not there is an abnormality, through comparison between the histogram in a normal state stored in the normal curve storage unit 33 and the histogram obtained by the histogram calculation unit 23. As the form of the abnormality, the following cases are assumed, for example: a case as shown in FIG. 7 where the average value of the load torque values is shifted to be larger than that in the histogram in a normal state; and a case as shown in FIG. 10 where two or more peaks exist in the histogram. Therefore, the following configuration is employed: peak parts of the histogram are counted at first, and then, if the number of the peak parts is one, determination is performed by the Mahalanobis distance determination unit 24a, whereas, if the number of the peak parts is two or more, determination is performed by the number-of-peaks determination unit 24b. Peak parts of a histogram can be calculated by differentiation.

The Mahalanobis distance determination unit 24a will be described. If the average value in the histogram is larger than the average value in a normal state as shown in FIG. 7, there is a possibility that, for example, a bearing of the electric motor 7 has been worn and deteriorated, or the mechanical equipment 8 has been worn and deteriorated. As shown in FIG. 8, the Mahalanobis distance determination unit 24a calculates a Mahalanobis distance from a normal-state position in relation to the average value and the standard deviation, and determines that there is an abnormality if the Mahalanobis distance is larger than a preset threshold value. As a threshold value calculating method, a maximum deviation $3\sigma$ is obtained in a case where, for example, a normal curve is decided from among curves obtained through a plurality of times of measurement, and a value obtained when separation is made by not less than the maximum deviation $3\sigma$ is used as the threshold value, whereby determination as to abnormality is performed on the basis of the threshold value. In addition, using past histogram information saved in the histogram saving unit 34 in time series, trend analysis of Mahalanobis distances is performed as shown in FIG. 9, and the result thereof is outputted so as to be displayed on the statistical result output unit 41, whereby the trend of deterioration can also be monitored.

The number-of-peaks determination unit 24b will be described. If two or more peak parts exist in the histogram as shown in FIG. 10, it is highly probable that torque abnormality has been cyclically occurring. For example, if a malfunction of a gear occurs as an abnormality, a cyclic torque abnormality sometimes occurs as a result of cyclic load torque being applied in a cycle obtained by dividing a rotational frequency by a speed-reduction ratio. In a case where the largest peak value is defined as A and the second largest peak value is defined as B as shown in FIG. 11, the number-of-peaks determination unit 24b calculates a peak ratio, i.e., B/A, and sets a threshold value for the calculated peak ratio, whereby a cyclic torque abnormality can be detected. Even if three or more peak parts are detected in the histogram, the peak ratio of the largest peak value and the second largest peak value may be calculated. In addition, using past histogram information saved in the histogram saving unit 34 in time series, trend analysis of peak ratios is performed as shown in FIG. 12, and the result thereof is outputted so as to be displayed on the statistical result output unit 41, whereby the trend of occurrences of abnormalities can also be monitored.

In step 107, in a case where it is determined that there is an abnormality by the Mahalanobis distance determination unit 24a or the number-of-peaks determination unit 24b of the abnormality determination unit 24, the process proceeds to step 108, an alarm is outputted from the alarm output unit 42 by means of an alarm sound, an abnormality lamp, or the like. Generally, a control center for which the electric motor diagnosis device 9 is used, is installed and managed in an electric room, and thus, a plurality of the electric motors 7 and a plurality of pieces of the mechanical equipment 8 can be easily monitored in the electric room, without anyone having to be dispatched to the place where the electric motors 7 are operated.

Finally, in step 109, data of the histogram obtained by the histogram calculation unit 23 is saved in the histogram saving unit 34 of the storage unit 30 in time series, so that the process is finished.

In a case where the trend analysis is performed, also data thereof may be stored.

As described above, diagnosis can be performed as to whether or not there is an abnormality in an electric motor, by performing statistic process on load torques which are equal in number to samples and which are calculated from information about voltages and currents having been sampled and inputted from the main circuit to which the electric motor is connected.

In the description of the above-described embodiment 1, the case has been described where the inputted voltages and currents are converted into voltages and currents in the dq-axis directions by the dq conversion calculation unit 21. However, a configuration may be employed where the voltage input unit 11 and the current input unit 12 have this conversion function.

In addition, in order to improve the accuracy of determination as to abnormality, a technique in which data analysis is performed in a state where data of a plurality of electric motors and a plurality of pieces of mechanical equipment are managed in a unified manner, is preferable. For example, with a combination of electric motors having similar outputs and similar pieces of mechanical equipment, similarity is obtained also in terms of load torque behavior. That is, the accuracy of detection of faults can be improved not through individual management of a plurality of pieces of equipment but through simultaneous management thereof.

An abnormality diagnosis technique for performing diagnosis as to abnormality while focusing not on load torque but on a probability density function of current, can also be considered. However, faults of load equipment such as the electric motor 7 and the mechanical equipment 8 are likely to influence load torque. Therefore, it is desirable to focus on load torque as in the present invention.

Furthermore, as a matter of course, the electric motor diagnosis device according to the present invention is applicable to an electric motor having high efficiency. An electric motor having high efficiency has a higher rated rotational speed than a general-purpose electric motor, and thus, owing to rise in the rotational speed, the workload increases and the output of the electric motor increases. Therefore, there is a possibility that current flowing to the electric motor so as to surpass a rated torque prescribed in the specifications of the electric motor increases, whereby a fault occurs that results in burnout of the electric motor in the worst case. The diagnosis and the monitoring using load torque as in the present invention are useful also in terms of preventing such a fault.

DESCRIPTION OF THE REFERENCE CHARACTERS

1      power system

2      main circuit

3      wiring circuit breaker

4      electromagnetic contactor

5      voltage detector

6      current detector

7      electric motor

8      mechanical equipment

9      electric motor diagnosis device

10     input unit

11     voltage input unit

12     current input unit

13     sampling speed setting unit

14     rating information input unit

20     logical calculation unit

21     dq conversion calculation unit

22     load torque calculation unit

23     histogram calculation unit

24     abnormality determination unit

30     storage unit

31     sampling speed storage unit

32     rating information storage unit

33     normal curve storage unit

34 histogram saving unit

40 output unit

41 statistical result output unit

42 alarm output unit

**Claims**

1. An electric motor diagnosis device (9) comprising:

   a load torque calculation unit (22) for calculating load torques of an electric motor (7) with use of voltages and currents having been sampled and inputted from a main circuit (2) to which the electric motor (7) is connected;
   a histogram calculation unit (23) for calculating an average value and a standard deviation of a probability density function of the load torques which are equal in number to the number of samples and which are calculated by the load torque calculation unit, to obtain a histogram, wherein the number of samples is equal to a number of the load torques, wherein the histogram is a graph with a horizontal axis being a load torque value and with a vertical axis being the probability density with the probability density function expressed in a normal distribution; and
   an abnormality determination unit (24) for calculating a peak ratio (B/A), wherein A is the largest peak value and wherein B is the second largest peak value and for setting a threshold value for the peak ratio (B/A), whereby a cyclic torque abnormality can be detected, and to determine whether or not there is an abnormality in the electric motor(7), if two or more peak parts exist in the histogram obtained by the histogram calculation unit(23).

2. The electric motor diagnosis device (9) according to claim 1, wherein the abnormality determination unit (24) is configured to perform trend analysis of peak ratios (B/A) with use of saved past histogram information.

**Patentansprüche**

1. Elektromotor-Diagnosevorrichtung (9), aufweisend:

   eine Lastdrehmoment-Recheneinheit (22) zum Berechnen von Lastdrehmomenten eines Elektromotors (7) unter Verwendung von Spannungen und Strömen, die von einer Hauptschaltung (2), mit der der Elektromotor (7) verbunden ist, abgetastet und eingegeben wurden;
   eine Histogramm-Recheneinheit (23) zum Berechnen eines Mittelwertes und einer Standardabweichung einer Wahrscheinlichkeitsdichtefunktion der Lastdrehmomente, deren Anzahl gleich der Anzahl der Abtastwerte ist und die durch die Lastdrehmoment-Recheneinheit berechnet werden, um ein Histogramm zu erhalten, wobei die Anzahl der Abtastwerte gleich einer Anzahl der Lastdrehmomente ist, wobei das Histogramm ein Graph mit einer horizontalen Achse, die ein Lastdrehmomentwert ist, und mit einer vertikalen Achse, die die Wahrscheinlichkeitsdichte mit der Wahrscheinlichkeitsdichtefunktion, ausgedrückt in einer Normalverteilung, ist; und eine Anomaliebestimmungseinheit (24) zum Berechnen eines Spitzenverhältnisses (B/A), wobei A der größte Spitzenwert ist und wobei B der zweitgrößte Spitzenwert ist, und zum Einstellen eines Schwellenwertes für das Spitzenverhältnis (B/A), wodurch eine zyklische Drehmomentanomalie erfasst werden kann, und zum Bestimmen, ob eine Anomalie in dem Elektromotor (7) vorliegt oder nicht, wenn zwei oder mehr Spitzenteile in dem durch die Histogramm-Recheneinheit (23) erhaltenen Histogramm vorhanden sind.

2. Elektromotor-Diagnosevorrichtung (9) nach Anspruch 1, wobei
   die Anomaliebestimmungseinheit (24) dazu ausgebildet ist, eine Trendanalyse der Spitzenverhältnisse (B/A) unter Verwendung gespeicherter früherer Histogramminformationen durchzuführen.

**Revendications**

1. Dispositif (9) de diagnostic de moteur électrique comportant :

une unité (22) de calcul de couples de charge servant à calculer des couples de charge d'un moteur électrique (7) en utilisant des tensions et des courants ayant été échantillonnés et introduits à partir d'un circuit principal (2) auquel le moteur électrique (7) est relié ;

une unité (23) de calcul d'histogramme servant à calculer une valeur moyenne et un écart-type d'une fonction de densité de probabilité des couples de charge dont le nombre est égal au nombre d'échantillons et qui sont calculés par l'unité de calcul de couples de charge, pour obtenir un histogramme, le nombre d'échantillons étant égal à un nombre des couples de charge, l'histogramme étant un graphe doté d'un axe horizontal qui est une valeur de couple de charge et d'un axe vertical qui est la densité de probabilité, la fonction de densité de probabilité étant exprimée dans une distribution normale ; et

une unité (24) de détermination d'anomalie servant à calculer un rapport de crêtes (B/A), A étant la plus grande valeur de crête et B étant la deuxième plus grande valeur de crête et à spécifier une valeur seuil pour le rapport de crêtes (B/A), une anomalie cyclique de couple pouvant ainsi être détectée, et à déterminer s'il existe ou non une anomalie dans le moteur électrique (7), s'il existe au moins deux parties de crêtes dans l'histogramme obtenu par l'unité (23) de calcul d'histogramme.

2. Dispositif (9) de diagnostic de moteur électrique selon la revendication 1,
l'unité (24) de détermination d'anomalie étant configurée pour effectuer une analyse de tendance de rapports de crêtes (B/A) en utilisant des informations sauvegardées d'histogrammes passés.

# FIG. 1

EP 3 489 700 B1

# FIG. 2

**20** LOGICAL CALCULATION UNIT

**21** dq CONVERSION CALCULATION UNIT

**22** LOAD TORQUE CALCULATION UNIT
- **22a** WINDING RESISTANCE VALUE CALCULATION UNIT
- **22b** FORGETTING COEFFICIENT CALCULATION UNIT
- **22c** SCALE FACTOR CALCULATION UNIT

**23** HISTOGRAM CALCULATION UNIT
- **23a** AVERAGE VALUE CALCULATION UNIT
- **23b** STANDARD DEVIATION CALCULATION UNIT

**24** ABNORMALITY DETERMINATION UNIT
- **24a** MAHALANOBIS DISTANCE DETERMINATION UNIT
- **24b** NUMBER-OF-PEAKS DETERMINATION UNIT

13

# FIG. 3

30

STORAGE UNIT

31

SAMPLING SPEED STORAGE UNIT

32

RATING INFORMATION STORAGE UNIT

33

NORMAL CURVE STORAGE UNIT

33a

AVERAGE VALUE STORAGE UNIT

33b

STANDARD DEVIATION STORAGE UNIT

34

HISTOGRAM SAVING UNIT

34a

AVERAGE VALUE SAVING UNIT

34b

STANDARD DEVIATION SAVING UNIT

# FIG. 4

kf
α

1.2
1.0
0.8
0.6
0.4
0.2
0

$\chi$    10$\chi$    100$\chi$

SAMPLING SPEED [S/s]

kf : FORGETTING COEFFICIENT
α  : SCALE FACTOR

# FIG. 5

START

101 INPUT VOLTAGE AND CURRENT

102 PERFORM d-AXIS AND q-AXIS CONVERSION

103 CALCULATE LOAD TORQUE

104 HAS SAMPLING FINISHED? — NO

YES

105 OBTAIN HISTOGRAM

106 COMPARE HISTOGRAM WITH NORMAL CURVE

107 HAS ABNORMALITY OCCURRED? — NO

YES

108 OUTPUT ALARM

109 SAVE HISTOGRAM

END

## FIG. 6

P(x) [a.u.]

AVERAGE VALUE

3σ

LOAD TORQUE [a.u.]

## FIG. 7

P(x)

NORMAL STATE

ABNORMAL STATE

0

LOAD TORQUE [Nm]

# FIG. 8

# FIG. 9

FIG. 10

FIG. 11

FIG. 12

**EP 3 489 700 B1**

**REFERENCES CITED IN THE DESCRIPTION**

**Patent documents cited in the description**

- JP 2003070287 A
- JP 2000513097 W